# EUROPEAN PATENT APPLICATION

(11) **EP 3 940 394 A1**
(43) Date of publication of application: **19.01.2022**
(21) Application number: 20773429.4
(22) Date of filing: 11.03.2020
(51) Int. Cl.: G01R 15/00, G01R 15/20

(54) **ELECTRIC CURRENT SENSOR**

(30) Priority: 15.03.2019 JP 2019048823
(71) Applicant: TDK Corporation, Tokyo 103-6128 (JP)
(72) Inventor: LO, Adrian, Tokyo 103-6128 (JP); MATSUMOTO, Isao, Tokyo 103-6128 (JP); HORI, Tatsumaro, Tokyo 103-6128 (JP); HAMAMURA, Takahiro, Tokyo 103-6128 (JP); OSADA, Takashi, Tokyo 103-6128 (JP); KAMI, Masafumi, Tokyo 103-6128 (JP)
(74) Representative: Epping - Hermann - Fischer
(86) International application number: PCT/JP2020/010561
(87) International publication number: WO 2020/189444

(57) **Abstract**

An object of the present invention is to provide a current sensor having a structure in which a magnetic sensor is less likely to be saturated even when the amount of current flowing in the bus bar is very large. The current sensor 1 includes a bus bar 10 in which current to be measured flows and a magnetic sensor 20 for detecting a magnetic field generated by the current flowing in the bus bar 10. The bus bar 10 includes a bypass bus bar 11 having a cylindrical structure and a sensing bus bar 12 disposed in a hollow area 13 surrounded by the bypass bus bar 11. The magnetic sensor 20 is disposed in the hollow area 13. An area having a zero magnetic field is formed in the hollow area 13 of the bypass bus bar 11. Thus, by disposing the sensing bus bar 12 in the zero magnetic field area, it is possible to accurately measure the amount of current flowing in the bus bar 10 while preventing saturation of the magnetic sensor 20 even when the current flowing in the bus bar is large.

## Description

### [Technical Field]

The present invention relates to a current sensor and, more particularly, to a current sensor using a magnetic sensor.

### [Background Art]

As a current sensor using a magnetic sensor, there are known current sensors described in Patent Document 1 and Patent Document 2. Patent Document 1 discloses a current sensor having a configuration in which two current paths, along which current to be measured flows in one direction and its opposite direction, respectively, are provided in a bus bar, and a magnetic sensor is disposed between the two current paths. Further, Patent Document 2 discloses a current sensor in which a bus bar is branched into two current paths, and magnetic sensors are provided respectively in the two current paths.

### [Citation List]

### [Patent Document]

[Patent Document 1] Japanese Patent No. 5,971,398
[Patent Document 2] WO 2017/018306

### [Summary of the Invention]

### [Problem to be Solved by the Invention]

However, in the current sensor described in Patent Document 1, a magnetic field generated from one current path and a magnetic field generated from the other current path strengthen each other, so that when the amount of current to be measured is large, the magnetic sensor is saturated. Further, in the current sensor described in Patent Document 2, the bus bar is branched into two current paths, so that the strength of the magnetic field to be applied to each magnetic sensor is advantageously reduced to 1/2. However, also in this case, when the amount of current to be measured is very large, the magnetic sensor is easily saturated.

It is therefore an object of the present invention to provide a current sensor having a structure in which a magnetic sensor is less likely to be saturated even when the amount of current flowing in the bus bar is very large.

### [Means for Solving the Problem]

A current sensor according to the present invention includes a bus bar in which current to be measured flows and a magnetic sensor for detecting a magnetic field generated by the current flowing in the bus bar. The bus bar includes a bypass bus bar having a cylindrical structure and a sensing bus bar disposed in a hollow area surrounded by the bypass bus bar, and the magnetic sensor is disposed in the hollow area.

According to the present invention, the bypass bus bar has a cylindrical structure, so that an area having a zero magnetic field is formed in the hollow area. Thus, by disposing the sensing bus bar in the zero magnetic field area, it is possible to accurately measure the amount of current flowing in the bus bar while preventing saturation of the magnetic sensor even when the current flowing in the bus bar is large.

In the present invention, the inner wall of the bypass bus bar may have a circular cross-sectional shape. This allows substantially the entire hollow area to become the zero magnetic field area.

In the present invention, the hollow area may be filled with an insulating material. This allows the positional relation between the bypass bus bar and the sensing bus bar to be fixed.

In the present invention, the bypass bus bar may have a slit at its one end, and the sensing bus bar may be fitted in the slit. This allows the positional relation between the bypass bus bar and the sensing bus bar to be fixed while reliably short-circuiting the bypass bus bar and sensing bus bar.

In the present invention, the sensing bus bar may have a section in which current flows in a direction different from the direction of the current flowing in the bus bar. This allows the influence of a magnetic field generated by the current flowing in the bypass bus bar to be eliminated more effectively.

### [Advantageous effects of the Invention]

As described above, according to the present invention, there can be provided a current sensor having a structure in which the magnetic sensor is less likely to be saturated even when the amount of current flowing in the bus bar is very large.

### [Brief Description of the Drawings]

FIG. 1 is a schematic perspective view illustrating the outer appearance of a current sensor 1 according to a first embodiment of the present invention.
FIG. 2 is a schematic exploded perspective view of the current sensor 1.
FIG. 3 is a schematic perspective view for explaining the structure of a measurement unit U.
FIG. 4 is an xy cross-sectional view of the current sensor 1.
FIG. 5 is a circuit diagram for explaining the connection relation between magnetic detection elements 21 and 22 when they are magnetoresistive elements.
FIG. 6 is an xy cross-sectional view illustrating a first example in which a sensing bus bar 12 and a magnetic sensor 20 are offset from the center.
FIG. 7 is an xy cross-sectional view illustrating a second example in which the sensing bus bar 12 and magnetic sensor 20 are offset from the center.
FIG. 8 is a partial cutaway view illustrating an example in which a part of the sensing bus bar 12 is curved in an arc shape.
FIGS. 9A to 9K are views illustrating variations of the cross-sectional shape of the bypass bus bar 11.
FIG. 10 is a view illustrating an example in which two bypass bus bars 11 and 15 are concentrically disposed.
FIG. 11 is a schematic perspective view of a current sensor according to a first modification.
FIGS. 12A and 12B are, respectively, a schematic exploded perspective view and a schematic perspective view of a current sensor according to a second modification.
FIG. 13 is a schematic exploded perspective view of a current sensor according to a third modification.
FIG. 14 is an xy cross-sectional view of the current sensor according to the third modification.
FIG. 15 is a schematic perspective view illustrating the outer appearance of a current sensor 2 according to a second embodiment of the present invention.
FIG. 16 is a schematic perspective view illustrating the outer appearance of a current sensor 3 according to a third embodiment of the present invention.
FIG. 17 is a schematic perspective view illustrating the outer appearance of a current sensor 4 according to a fourth embodiment of the present invention.

### [Mode for Carrying Out the Invention]

Preferred embodiments of the present invention will be described below in detail with reference to the accompanying drawings.

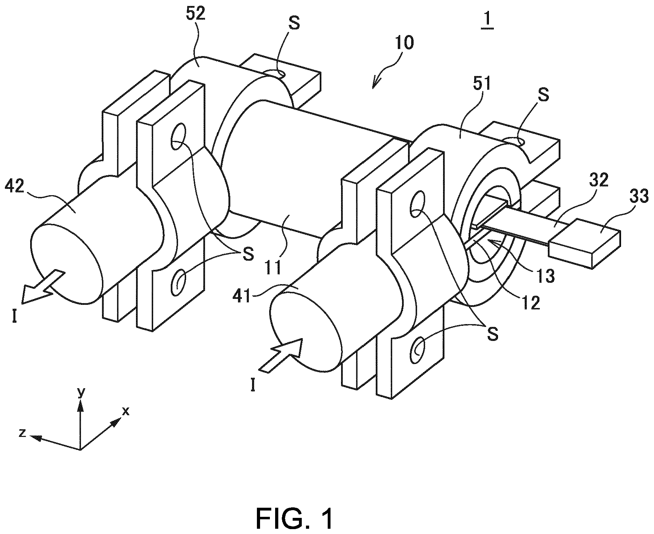

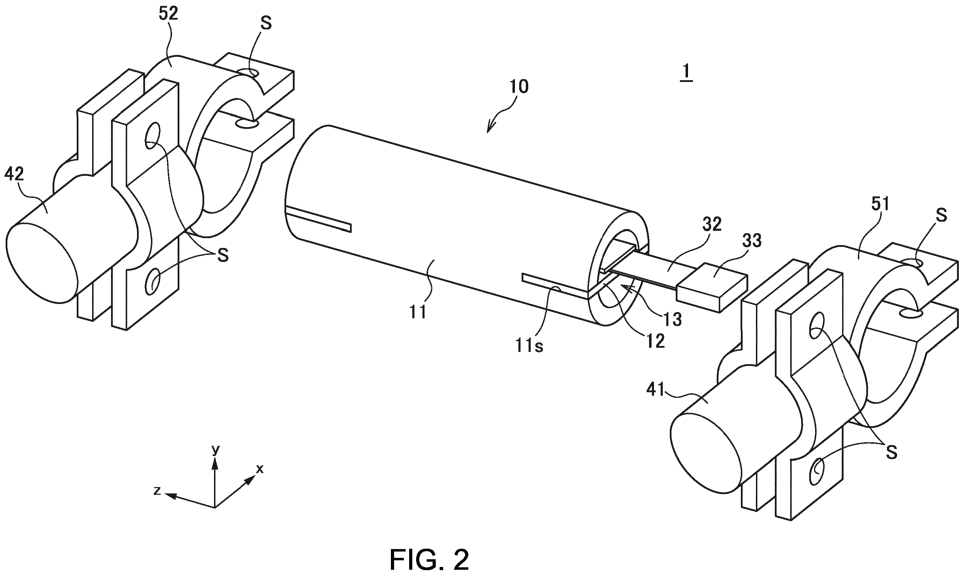

FIG. 1 is a schematic perspective view illustrating the outer appearance of a current sensor 1 according to a first embodiment of the present invention. FIG. 2 is a schematic exploded perspective view of the current sensor 1.

As illustrated in FIGS. 1 and 2, the current sensor 1 according to the present embodiment has a bus bar 10 attached to current cables 41 and 42 in which current I to be measured flows. The current cable 41 is fixed to one end of the bus bar 10 using a cramp member 51, and the current cable 42 is fixed to the other end of the bus bar 10 using a cramp member 52. The cramp members 51 and 52 each have a plurality of screw holes S, not-shown bolts are inserted through the screw holes S, and nuts are screwed onto the bolts, whereby the cramp member 51, current cable 41, and the one end of the bus bar 10 are fastened, and the cramp member 52, current cable 42, and the other end of the bus bar 10 are fastened. Thus, when the current I is made to flow in the current cables 41 and 42, current in the z-direction flows in the bus bar 10.

The bus bar 10 incudes a bypass bus bar 11 having a cylindrical structure and a sensing bus bar 12 disposed in a hollow area 13 surrounded by the bypass bus bar 11. The bypass bus bar 11 and the sensing bus bar 12 are each made of a good conductor, such as copper or aluminum. In the present embodiment, the inner and outer circumferences of the bypass bus bar 11 each have a substantially true circular shape. The bypass bus bar 11 and the sensing bus bar 12 are connected in parallel, whereby a part of the current I in the bus bar 10 flows in the bypass bus bar 11, and the remaining part thereof flows in the sensing bus bar 12. In the present embodiment, the bypass bus bar 11 is sufficiently larger in cross-sectional area than the sensing bus bar 12, so that most of the current I in the bus bar 10 flows in the bypass bus bar 11, and the amount of current flowing in the sensing bus bar 12 is a fraction of the current I, preferably, 1/10 or less.

In the hollow area 13 of the bypass bus bar 11, a measurement unit including the sensing bus bar 12 is disposed.

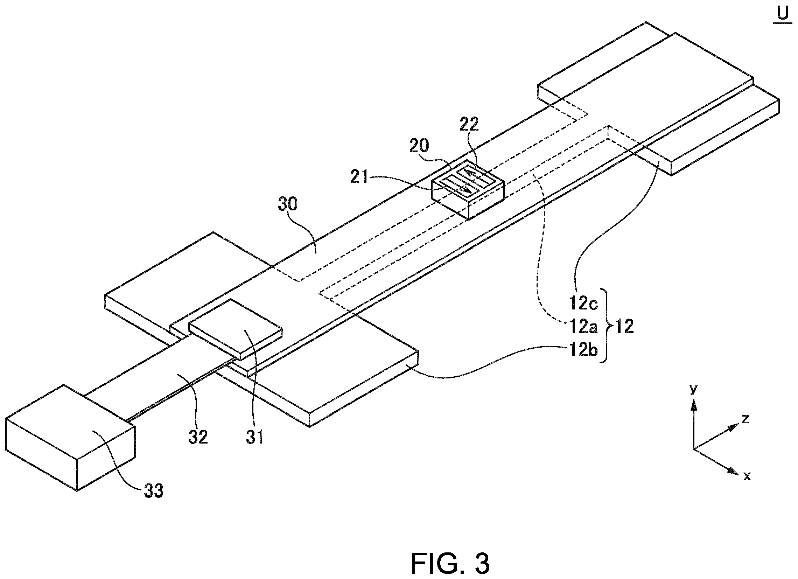

FIG. 3 is a schematic perspective view for explaining the structure of a measurement unit U.

As illustrated in FIG. 3, the measurement unit U has a circuit board 30, a sensing bus bar 12 fixed to the back surface side of the circuit board 30, and a magnetic sensor 20 mounted on the front surface side of the circuit board 30. The sensing bus bar 12 is a member obtained by machining a metal plate having a constant thickness in the y-direction and has a measurement section 12a having a small width in the x-direction and end sections 12b and 12c positioned at both ends of the measurement section 12a. The magnetic sensor 20 is a device for detecting a magnetic field generated by current flowing in the measurement section 12a of the sensing bus bar 12 and is mounted at a position overlapping the measurement section 12a as viewed in the z-direction.

The magnetic sensor 20 has two magnetic detection elements 21 and 22 which are located at different positions in the z-direction. The magnetic sensitive direction (positive x-direction) of the magnetic detection element 21 and the magnetic sensitive direction (negative x-direction) of the magnetic detection element 22 differ by 180°. The magnetic detection elements 21 and 22 are not particularly limited in type and may be a hall element or a magnetoresistive element.

The end section 12b of the sensing bus bar 12 has an x-direction width having substantially the same dimension as the outer diameter of the bypass bus bar 11 and is fitted in the slit 11s to be short-circuited to the one end of the bypass bus bar 11. On the other hand, the end section 12c of the sensing bus bar 12 has an x-direction width having substantially the same dimension as the inner diameter of the bypass bus bar 11. Thus, when the sensing bus bar 12 is inserted into the bypass bus bar 11, the other end of the bypass bus bar 11 and the end section 12c of the sensing bus bar 12 are short-circuited. As a result, the bypass bus bar 11 and the sensing bus bar 12 are connected in parallel.

A terminal 31 connected to the magnetic sensor 20 is provided at one end of the circuit board 30 in the z-direction. The terminal 31 is connected to a connector 33 through wiring 32. The connector 33 is connected to an external control circuit or an external power supply circuit.

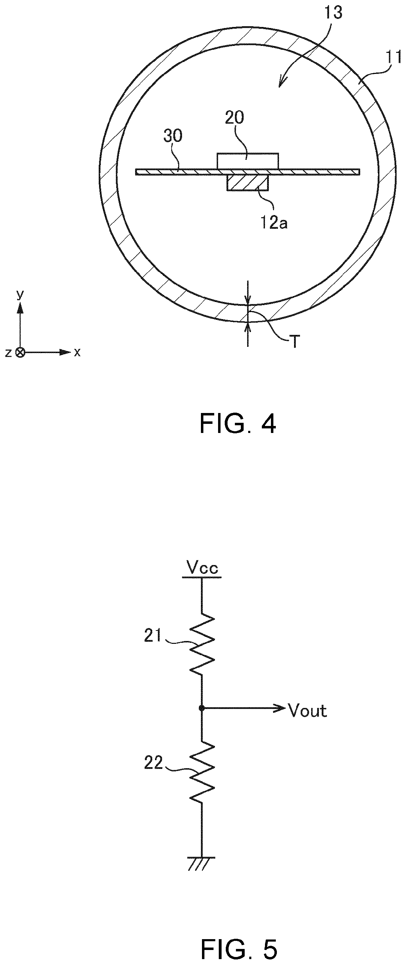

FIG. 4 is an xy cross-sectional view of the current sensor 1 according to the present embodiment.

In the present embodiment, the inner and outer circumferences of the bypass bus bar 11 each have a substantially true circular shape, and a thickness T thereof is substantially constant in the circumferential direction. It follows that the current density of the current in the x-direction flowing in the bypass bus bar 11 is substantially uniform in the circumferential direction. As a result, in the hollow area 13 of the bypass bus bar 11, a magnetic field generated by the current flowing in the bypass bus bar 11 is substantially completely canceled. That is, the hollow area 13 becomes a zero magnetic field area substantially free of a magnetic field due to the current flowing in the bypass bus bar 11.

Since, in the current sensor 1 according to the present embodiment, the sensing bus bar 12 and magnetic sensor 20 are disposed in the thus configured hollow area 13, a magnetic field to be applied to the magnetic sensor 20 is substantially only a magnetic field due to the current flowing in the sensing bus bar 12. This allows the magnetic sensor 20 to selectively detect a magnetic field generated by the current flowing in the sensing bus bar 12. Further, since the magnetic sensitive directions of the magnetic detection elements 21 and 22 provided in the magnetic sensor 20 differ by 180°, there occurs a difference between the output of the magnetic detection element 21 and the output of the magnetic detection element 22 according to the current flowing in the sensing bus bar 12. The hollow area 13 may not necessarily remain hollow but may be filled with an insulating material.

FIG. 5 is a circuit diagram for explaining the connection relation between the magnetic detection elements 21 and 22 when they are magnetoresistive elements.

When the magnetic detection elements 21 and 22 are magnetoresistive elements, they are connected in series between a power supply Vcc and a ground GND. A potential Vout at the connection point between the magnetic detection elements 21 and 22 is output outside through the connector 33. The magnetic sensitive directions of the magnetic detection elements 21 and 22 differ by 180° as described above, so that when current flows in the sensing bus bar 12, the resistance values of the magnetic detection elements 21 and 22 change to change the output potential Vout. The level of the output potential Vout is proportional to the current flowing in the sensing bus bar 12, based on which the amount of current I can be calculated. It is also possible to perform closed-loop control by applying a cancelling magnetic field to the magnetic detection elements 21 and 22 by using a compensation coil.

As described above, in the present embodiment, the bus bar 10 is branched into the bypass bus bar 11 having a cylindrical structure and the sensing bus bar 12, and the sensing bus bar 12 is disposed in the hollow area 13 of the bypass bus bar 11, thus allowing the magnetic sensor 20 to selectively detect only a magnetic field generated from the sensing bus bar 12. Thus, even when the current I flowing in the bus bar 10 is large, the strength of the magnetic field to be applied to the magnetic sensor 20 is significantly reduced to thereby prevent saturation of the magnetic sensor 20.

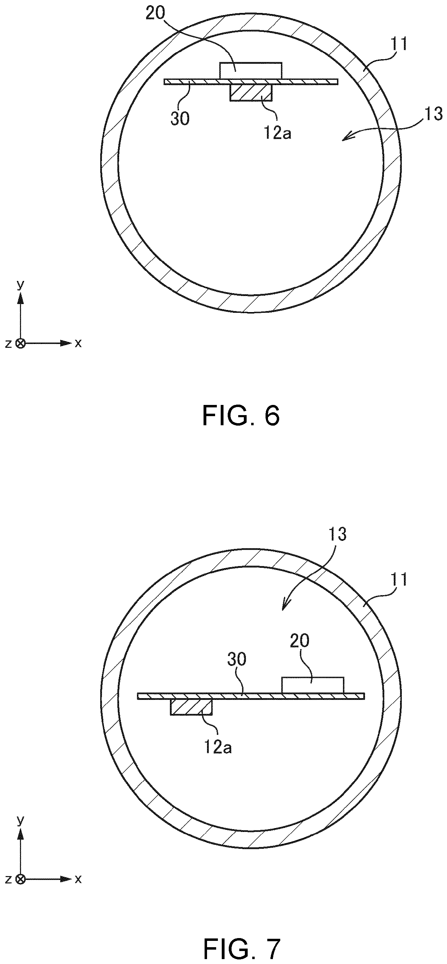

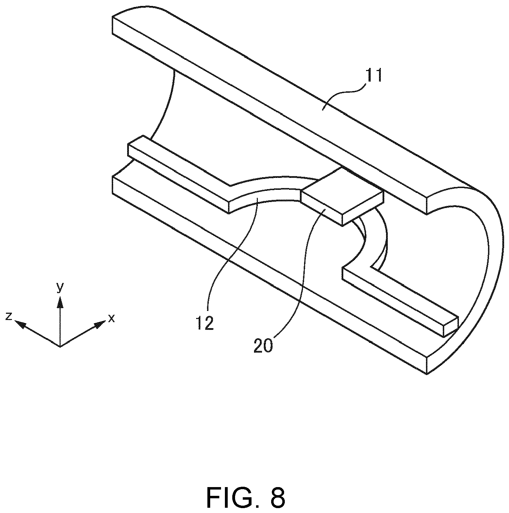

In addition, in the present embodiment, since the inner and outer circumferences of the bypass bus bar 11 each have a substantially true circular shape, a magnetic field generated by the current flowing in the bypass bus bar 11 is canceled in substantially the entire hollow area 13. That is, substantially the entire hollow area 13 becomes a zero magnetic field area, allowing the sensing bus bar 12 and magnetic sensor 20 to be disposed at desired positions within the hollow area 13. For example, as illustrated in FIG. 6, the sensing bus bar 12 and magnetic sensor 20 may be offset in the positive y-direction. Alternatively, as illustrated in FIG. 7, the sensing bus bar 12 and magnetic sensor 20 may be offset in the negative x-direction and positive x-direction, respectively. The arrangement illustrated in FIG. 7 can be obtained by curving a part of the sensing bus bar 12 into an arc shape, as illustrated in a partial cutaway view of the bypass bus bar 11 of FIG. 8. In the example of FIG. 8, a part of the sensing bus bar 12 is curved in an arc shape about the y-axis. Since a y-direction component of a magnetic field is applied to the magnetic sensor 20 in this case, a magnetic sensor whose magnetic sensitive direction is parallel to the y-direction is used as the magnetic sensor 20.

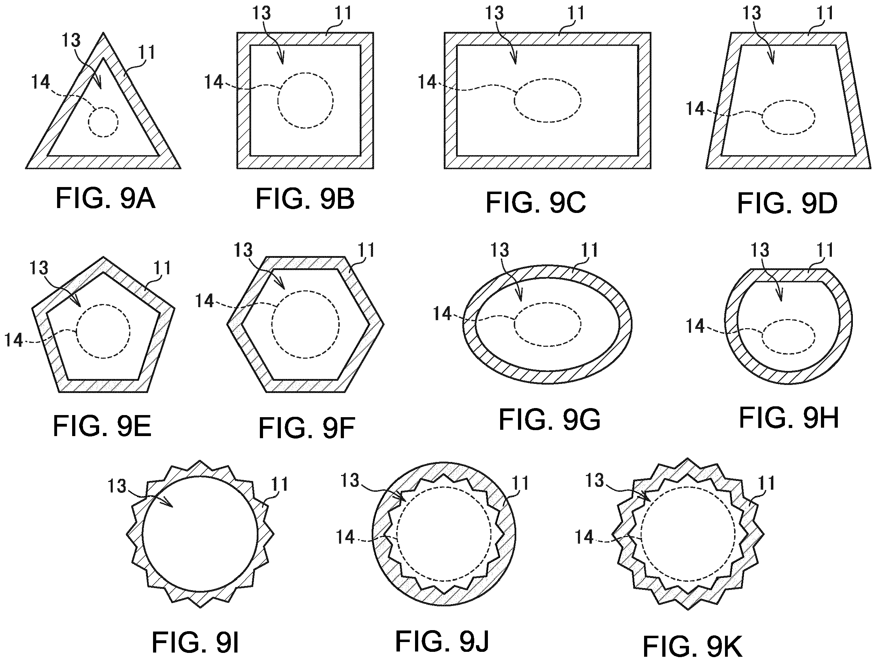

However, in the present invention, the inner and outer circumferences of the bypass bus bar 11 each may not necessarily have a substantially true circular shape but may have various shapes as long as the bypass bus bar 11 has a cylindrical shape. For example, as illustrated in FIGS. 9A to 9H, the xy cross section of the bypass bus bar 11 may have a triangular, a square, a rectangular, a trapezium, a pentagonal, a hexagonal, or an ovel shape, or a circular shape partially having a flattened portion. Further, as illustrated in FIGS. 9I to 9K, the inner surface or outer surface of the bypass bus bar 11 may not be flat but irregular.

However, when the inner and outer circumference of the bypass bus bar 11 each do not have a true circular shape, a magnetic field generated by the current flowing in the bypass bus bar 11 is not completely canceled in some part of the hollow area 13 but remains. For example, when the bypass bus bar 11 has a triangular cross section as illustrated in FIG. 9A, a magnetic field generated by the current flowing in the bypass bus bar 11 remains in areas near the corner portions, so that when the magnetic sensor 20 is disposed in such an area, measurement errors may occur. However, even when the inner and outer circumferences of the bypass bus bar 11 each do not have a true circular shape, a zero magnetic field area 14 where a magnetic field is substantially completely canceled exists in some part of the hollow area 13, and hence the magnetic sensor 20 is disposed in the zero magnetic field area 14. In this case, when the hollow area 13 is filled with an insulating material to fix the position of the magnetic sensor 20 in the hollow area 13, the magnetic sensor 20 can reliably be disposed in the zero magnetic field area 14.

Although it depends on the cross-sectional shape of the bypass bus bar 11, the zero magnetic field area 14 exists mainly at the center portion of the hollow area 13. The occupancy of the zero magnetic field area 14 in the hollow area 13 becomes higher as the cross-sectional shape of the bypass bus bar 11 is more close to a true circle. For example, as illustrated in FIG. 9I, when only the outer surface of the bypass bus bar 11 has irregularity, a slight difference occurs, according to the thickness of the bypass bus bar 11, in the density of the current flowing in the bypass bus bar 11 in the circumferential direction; however, the inner surface of the bypass bus bar 11 is flat, so that substantially the entire hollow area 13 becomes the zero magnetic field area 14.

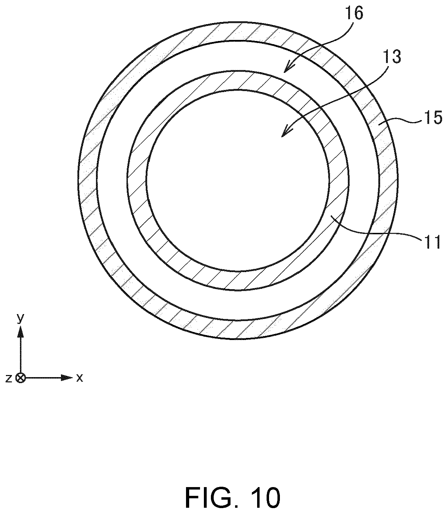

Further, the number of the bypass bus bars 11 is not limited to one, but two bypass bus bars 11 and 15 may be used as illustrated in FIG. 10. The bypass bus bar 15 is a cylinder having a larger diameter and has the bypass bus bar 11 in the hollow area thereof. That is, the two bypass bus bars 11 and 15 are concentrically disposed. Such a double structure of the bypass bus bars 11 and 15 can further reduce the ratio of the current flowing in the sensing bus bar 12 and make substantially the entire hollow area 13 become the zero magnetic field area. In this case, when an area 16 which is a gap between the bypass bus bars 11 and 15 is filled with an insulating material, the positional relation between the bypass bus bars 11 and 15 can be fixed.

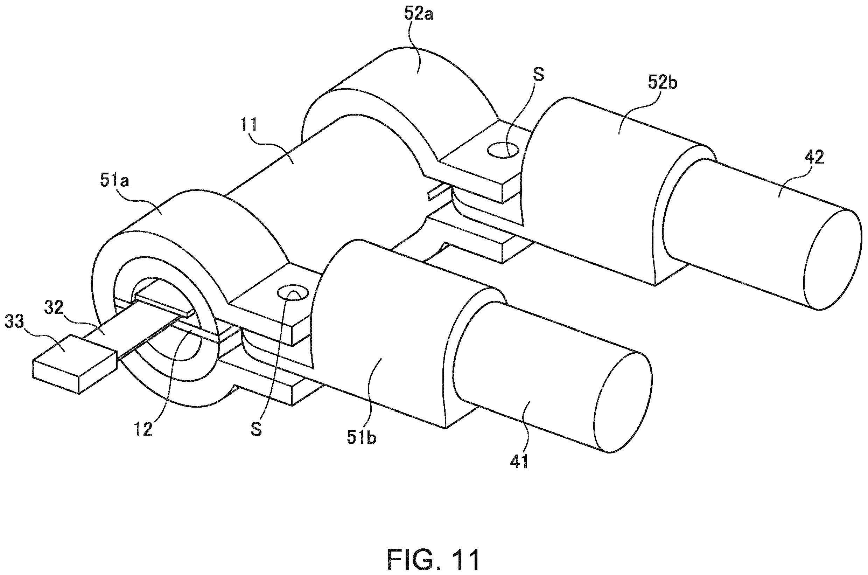

Further, the cramp members 51 and 52 are not particularly limited in shape. As a first modification illustrated in FIG. 11, cramp members 51a and 52a fastened to the bus bar 10 and terminal members 51b and 52b connected to the current cables 41 and 42 may be separately provided and fastened together using bolts and nuts.

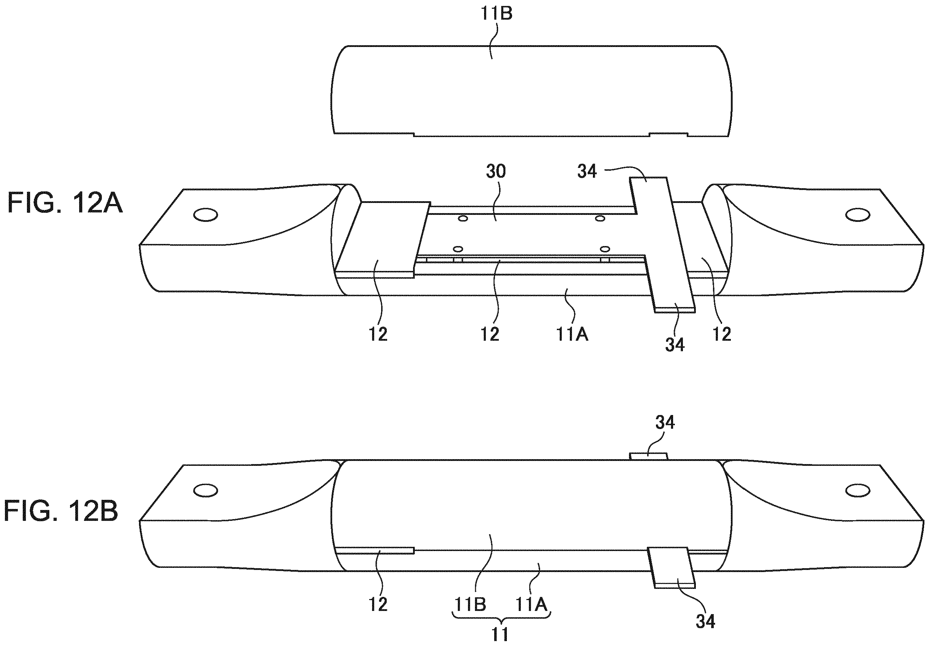

Further, the bypass bus bar 11 may not necessarily be formed as a single member. As a second modification illustrated in FIGS. 12A and 12B, two bypass members 11A and 11B may be combined to form the cylindrical structure of the bypass bus bar 11. In the example illustrated in FIGS. 12A and 12B, the circuit board 30 has a T-shape, and end portions 34 of the circuit board 30 in the x-direction protrude from the bypass bus bar 11. On the end portions 34 protruding from the bypass bus bar 11, a terminal electrode to be connected to the magnetic sensor 20 or a connector may be disposed.

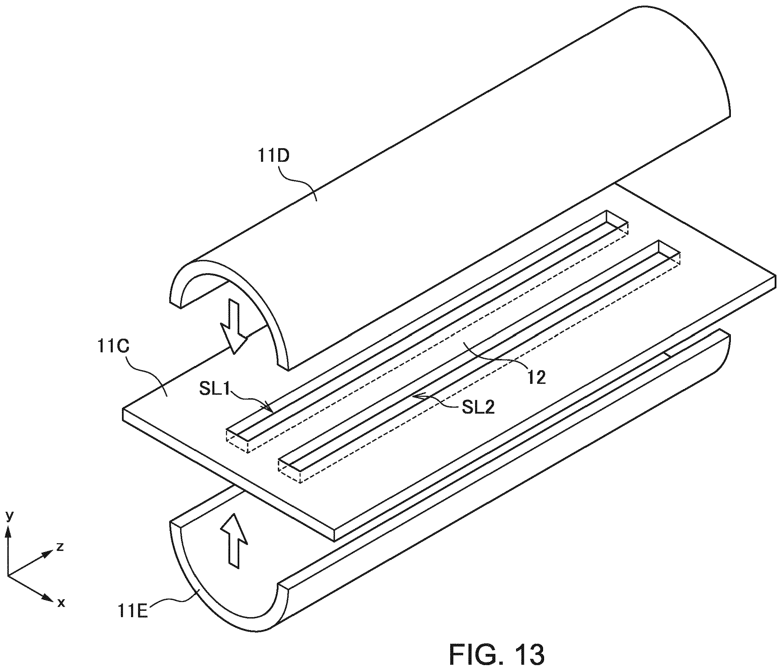

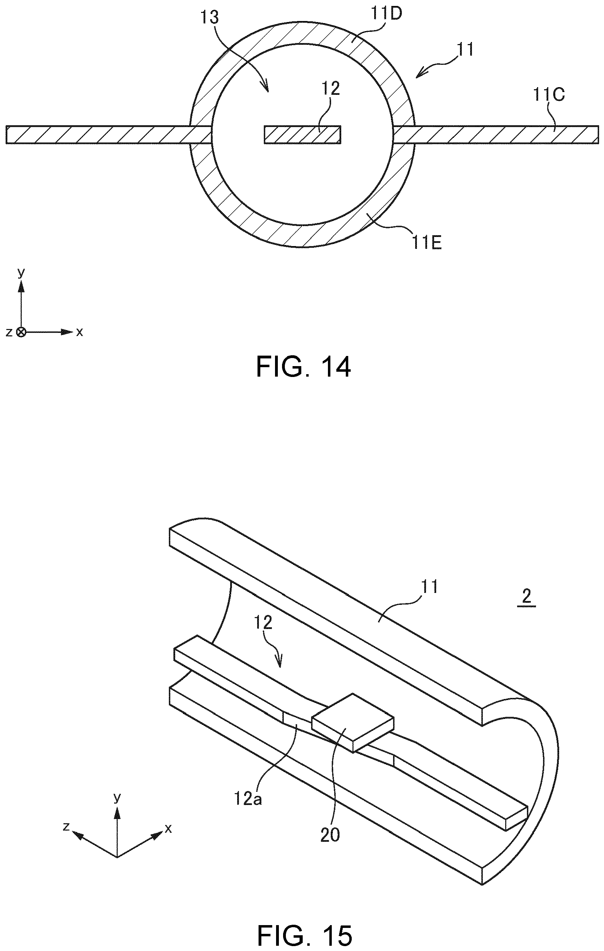

Further, as a third modification illustrated in FIG. 13, the bypass bus bar 11 may be constituted by three bypass members including two bypass members 11D and 11E each having a shape obtained by cutting a cylinder by half and a plate-like bypass member 11C sandwiched by the two bypass members 11D and 11E. The plate-like bypass member 11C has two slits SL1 and SL2 extending in the z-direction, and an area between the two slits SL1 and SL2 serves as the sensing bus bar 12. When the bypass member 11C is sandwiched by the bypass members 11D and 11E, the sensing bus bar 12 is surrounded by the bypass bus bar 11 constituted of the bypass members 11C to 11E, as illustrated in FIG. 14 which is an xy cross-sectional view. Then, when the magnetic sensor 20 (not illustrated in FIG. 14) is disposed in the hollow area 13 surrounded by the bus bar 11, only the current flowing in the sensing bus bar 12 can selectively be detected.

FIG. 15 is a schematic perspective view illustrating the outer appearance of a current sensor 2 according to a second embodiment of the present invention.

As illustrated in FIG. 15, in the current sensor 2 according to the present embodiment, the sensing bus bar 12 does not linearly extend in the x-direction, but the measurement section 12a extends obliquely with respect to the z-direction. That is, the x-direction position of the measurement section 12a varies according to its z-direction position. Thus, when current flows in the measurement section 12a of the sensing bus bar 12, a magnetic field generated by this current includes a z-direction component. In the present embodiment, the amount of the current flowing in the bus bar 10 can be measured by detecting the z-direction component of a magnetic field by means of the magnetic sensor 20.

As described above, the sensing bus bar 12 may have a section in which current flows in a direction different from the direction (z-direction) of the current flowing in the bypass bus bar 11. With this configuration, it is possible to further reduce measurement errors. This is because current in the bypass bus bar 11 flows in the z-direction, so that a magnetic field generated by this current has substantially no z-direction component.

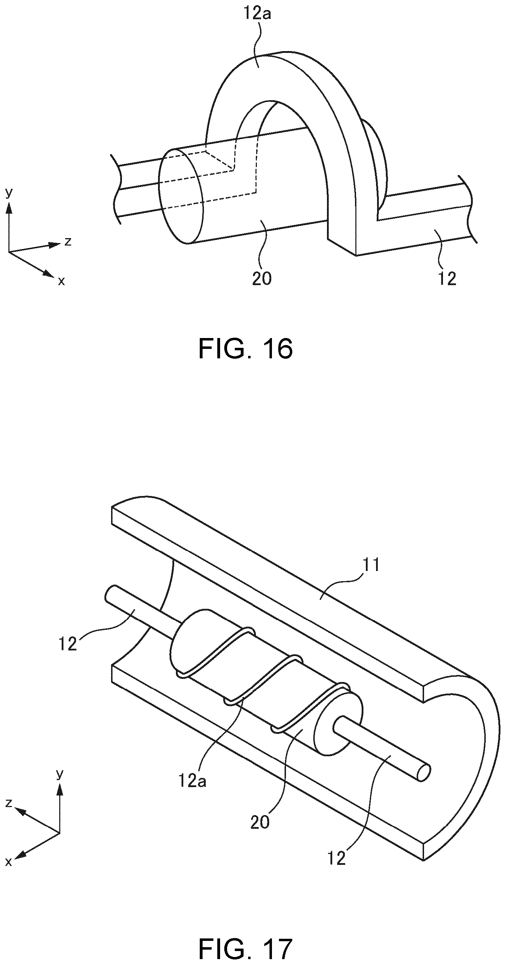

FIG. 16 is a schematic perspective view illustrating the outer appearance of a current sensor 3 according to a third embodiment of the present invention.

As illustrated in FIG. 16, in the current sensor 3 according to the present embodiment, the measurement section 12a of the sensing bus bar 12 has an arc shape about the z-axis. Thus, when current flows in the measurement section 12a of the sensing bus bar 12, a magnetic field generated by this current includes a z-direction component. In the present embodiment as well, the amount of the current flowing in the bus bar 10 can be measured by detecting the z-direction component of a magnetic field by means of the magnetic sensor 20.

FIG. 17 is a schematic perspective view illustrating the outer appearance of a current sensor 4 according to a fourth embodiment of the present invention.

As illustrated in FIG. 17, in the current sensor 4 according to the present embodiment, the measurement section 12a of the sensing bus bar 12 has a helical shape about the z-axis. Thus, when current flows in the measurement section 12a of the sensing bus bar 12, a magnetic field generated by this current includes a z-direction component. In the present embodiment as well, the amount of the current flowing in the bus bar 10 can be measured by detecting the z-direction component of a magnetic field by means of the magnetic sensor 20.

While the preferred embodiments of the present invention have been described, the present invention is not limited to the above embodiments, and various modifications may be made within the scope of the present invention, and all such modifications are included in the present invention.

### [Reference Signs List]

1-4 current sensor
10 bus bar
11, 15 bypass bus bar
11A-11E bypass member
11s slit
12 sensing bus bar
12a measurement section
12b, 12c end section
13, 16 hollow area
14 zero magnetic field area
20 magnetic sensor
21, 22 magnetic detection element
30 circuit board
31 terminal
32 wiring
33 connector
34 protruding part
41, 42 current cable
51, 52, 51a, 52a cramp member
51b, 52b terminal member
S screw hole
SL1, SL2 slit
U measurement unit

## Claims

1. A current sensor comprising:
a bus bar in which current to be measured flows; and
a magnetic sensor for detecting a magnetic field generated by the current flowing in the bus bar,
wherein the bus bar includes a bypass bus bar having a cylindrical structure and a sensing bus bar disposed in a hollow area surrounded by the bypass bus bar, and
wherein the magnetic sensor is disposed in the hollow area.

2. The current sensor as claimed in claim 1, wherein an inner wall of the bypass bus bar has a circular cross-sectional shape.

3. The current sensor as claimed in claim 1 or 2, wherein the hollow area is filled with an insulating material.

4. The current sensor as claimed in any one of claims 1 to 3,
wherein the bypass bus bar has a slit at its one end, and
wherein the sensing bus bar is fitted in the slit.

5. The current sensor as claimed in any one of claims 1 to 4, wherein the sensing bus bar has a section in which current flows in a direction different from the direction of the current flowing in the bus bar.
